# FASCICULE DE BREVET EUROPEEN

(11) **EP 0 760 162 B1**
(45) Date de publication et mention de la délivrance du brevet: **16.08.2000**
(21) Numéro de dépôt: 95920950.3
(22) Date de dépôt: 17.05.1995
(51) Int. Cl.: H01L 21/76, H01L 21/265

(54) **PROCEDE DE REALISATION D'UNE STRUCTURE A FAIBLE TAUX DE DISLOCATIONS COMPRENANT UNE COUCHE D'OXYDE ENTERREE DANS UN SUBSTRAT**
VERFAHREN ZUR HERSTELLUNG EINER STRUKTUR MIT NIEDRIGEN KONZENTRATIONSDEFEKTEN MIT EINER IN EINEM HALBLEITERSUBSTRAT BEGRABENEN OXYDSCHICHT
METHOD FOR PRODUCTION OF A STRUCTURE WITH A LOW LEVEL OF DISLOCATIONS AND HAVING AN OXIDE LAYER BURIED IN A SEMICONDUCTOR SUBSTRATE

(30) Priorité: 18.05.1994 FR 9406061
(43) Date de publication de la demande: 05.03.1997
(73) Titulaire: COMMISSARIAT A L'ENERGIE ATOMIQUE, 75015 Paris (FR)
(72) Inventeur: ASPAR, Bernard, F-38140 Rives (FR); MARGAIL, Jacques, F-38000 Grenoble (FR); PUDDA, Catherine, F-38170 Seyssinet (FR)
(74) Mandataire: Des Termes, Monique
(86) Numéro de dépôt international: FR9500644
(87) Numéro de publication internationale: WO9531825

(56) Documents cités:
- IEEE TRANSACTIONS ON NUCLEAR SCIENCE, vol. NS-30, no. 2, Avril 1983 NEW YORK US, pages 1722-1725, A.H. HAMDI ET AL. 'VLSI MATZERIALS: A COMPARISON BETWEEN BURIED OXIDE SOI AND SOS'
- IEEE TRANSACTIONS ON ELECTRON DEVICES, vol. 38, no. 1, Janvier 1991 NEW YORK US, pages 61-66, A.BUCZKOWSKI ET AL. 'CONDUCTIVITY-TYPE CONVERSION IN MULTIPLE-IMPLANT/MULTIPLE-ANNEAL SOI'

## Description

### Domaine technique

La présente invention concerne un procédé de réalisation d'une structure à faible taux de dislocations comprenant une couche d'oxyde enterrée dans un substrat semi-conducteur. Elle se rapporte notamment à la fabrication de structures du type silicium sur isolant dites SOI (Silicon On Insulator) mettant en oeuvre un procédé d'implantation d'oxygène connu sous la désignation SIMOX (Separation by IMplantation of OXygen). L'invention trouve de nombreuses applications en microélectronique et en particulier pour la réalisation de circuits intégrés du type CMOS (Complementary Metal-Oxide Semiconductor).

### Etat de la technique antérieure

Pour le développement des technologies concernant des structures SOI avec le procédé SIMOX, l'un des enjeux majeurs est de réduire le taux de défauts cristallins.

Les défauts cristallins, et en particulier les dislocations des structures SOI de type SIMOX figurent parmi leurs principaux inconvénients. Les structures SOI comportent un film de silicium dont les imperfections cristallines constituent un obstacle ou tout au moins une limitation pour la réalisation de certains composants ou circuits.

Ceci est vrai en particulier pour les composants du type bipolaire, les transistors à effet de champ à jonction (JFET) et pour les applications des technologies avancées du type CMOS ULSI (Ultra Large Scale Integration) où les densités d'intégration sont très importantes.

Les documents (1), (2) et (3) référencés à la fin de la description donnent des exemples de comportement des défauts des structures de type SOI après une étape d'épitaxie d'une couche de matériau semi-conducteur.

Dans leurs travaux, Liaw et al. (document (1)) concluent que l'épitaxie de silicium permet de diminuer, de façon modérée, le taux de défauts dans le film de silicium par piégeage des dislocations entre elles (de 2,5.10⁷ cm⁻² à 4.10⁶cm⁻² pour une épitaxie de 18,2 µm). Ce mécanisme n'est efficace que dans le cas de forts taux de défauts. Un calcul simple, en considérant une inclinaison des dislocations de 35° par rapport à la normale, montre que pour une épitaxie de 1 µm, le taux de défauts doit être supérieur à 2.10⁷cm⁻² pour qu'il y ait une probabilité non nulle d'interaction entre deux dislocations.

D'autre part, Liaw et al. concluent que la qualité de la couche formée ne dépend pas des traitements thermiques avant épitaxie.

Le document (2) aboutit à une conclusion identique en montrant que sur un échantillon possédant une densité de dislocations élevée (10⁹cm⁻²) une épitaxie d'une couche d'une épaisseur de 5 µm permet d'obtenir une densité de dislocations légèrement plus faible (10⁸cm⁻²).

Les différentes études indiquent que pour de fortes densités de dislocations (>10⁷cm⁻²)' l'épitaxie d'une forte épaisseur de silicium (>4µm) permet de diminuer légèrement la densité de dislocations alors que pour de faibles épaisseurs de silicium épitaxié, aucune modification de la densité de défauts n'apparaît (document (3)).

En fait, dans tous les cas, le seul mécanisme qui intervient est le piégeage des dislocations entre elles.

Deux autres documents (IEEE Trans. on Nuclear Science, NS-30, n° 2, pages 1722 à 1725 et IEEE Trans. on Electron Devices, 38(1), pages 61 à 66) décrivent aussi des procédés où un substrat implanté à l'oxygène et recuit est soumis à une epitaxie puis à un autre recuit.

Il apparait que les dislocations dans les structures obtenues par le procédé SIMOX ont essentiellement deux origines qui sont d'une part l'état de la surface du substrat et, d'autre part, l'état de la zone perturbée à l'interface entre la couche enterrée et le matériau semi-conducteur.

Un objet de l'invention est de proposer un procédé permettant d'obtenir une structure avec une densité de dislocations très inférieure à celles des structures connues.

### Exposé de l'invention

L'invention concerne un procédé de réalisation d'une structure épitaxiée à faible taux de dislocations, cette structure comprenant une couche d'oxyde dans un substrat en un matériau semi-conducteur, ce procédé comportant successivement :
- au moins une implantation d'ions oxygène dans le substrat à travers une surface de ce dernier pour former une couche enterrée d'oxyde,
- au moins un premier traitement thermique de conditionnement du substrat à une température inférieure à la température de fusion du matériau semi-conducteur,
- une épitaxie d'une couche d'un matériau semi-conducteur sur la surface du substrat et,
- un second traitement thermique à une température inférieure à la température de fusion du matériau semi-conducteur du substrat et à celle du matériau de la couche épitaxiée pour éliminer des dislocations de la structure se trouvant dans une configuration énergétique instable, dans lequel le premier traitement thermique est effectuée à une température choisie dans une gamme de température de 800 °C à 1405 °C et le deuxième traitement thermique est effectué à une température supérieure ou égale à 1200 °C, pour dissoudre sensiblement tous les précipités d'oxyde formés au cours de l'implantation, pour libérer les dislocations qui se recombinent alors au cours du deuxième traitement thermique.

L'implantation d'oxygène dans le substrat est l'étape de base du procédé SIMOX. Des ions oxygène accélérés sont implantés soit sous leur forme atomique O⁺ soit sous leur forme moléculaire O₂⁺. L'implantation peut avoir lieu soit en une seule étape soit en plusieurs étapes. Dans ce cas, les étapes d'implantation sont alternées avec des recuits, ce qui revient à répéter et alterner plusieurs fois les étapes d'implantation et de premier traitement thermique du procédé. On peut se référer à ce propos au document (4) référencé à la fin de la description.

Le procédé de l'invention tient essentiellement en l'association des étapes d'au moins un premier traitement thermique, de l'épitaxie et du second traitement thermique. Chacune de ces étapes est essentielle et déterminante pour l'efficacité du procédé.

Le premier traitement thermique, appelé aussi prérecuit, permet de conditionner le matériau. On entend par conditionnement du matériau, le fait d'y induire un certain nombre de modifications telles qu'une redistribution de l'oxygène implanté, une redistribution de certaines dislocations déjà existantes dans le matériau, ainsi qu'un relâchement d'un certain nombre de contraintes ; ceci peut par ailleurs occasionner de nouvelles dislocations. Ce premier traitement, ou prérecuit, peut, dans le procédé, apparaître comme une ou plusieurs étapes indépendantes et/ou faire partie du procédé d'épitaxie. Le premier traitement thermique est assimilé dans ce dernier cas à une étape de conditionnement, de préparation et de nettoyage du matériau, avant épitaxie, cette étape étant effectuée en chauffant le substrat sous atmosphère contrôlée.

Après le premier traitement thermique, l'état de surface du substrat est satisfaisant pour permettre une épitaxie de bonne qualité. Le matériau semi-conducteur utilisé pour l'épitaxie est de préférence le même que le matériau du substrat dans lequel est implanté l'oxygène et en particulier ce matériau est du silicium pour un substrat de silicium. Bien entendu, d'autres matériaux peuvent être utilisés.

Les défauts de structure cristalline débouchant à la surface du substrat se propagent dans la couche formée par épitaxie. Les dislocations traversent cette couche et leur longueur augmente avec son épaisseur.

L'énergie d'une dislocation qui est directement proportionnelle à sa longueur, augmente donc lors de l'épitaxie. L'épitaxie ne modifie donc pas la densité des dislocations mais place ces dislocations dans une configuration énergétique instable. On peut noter à ce sujet qu'il est souhaitable que la couche d'épitaxie ait une épaisseur d'au moins 0,05µm et de préférence de l'ordre du micromètre afin d'avoir une diminution significative des dislocations.

Selon un aspect de l'invention au moins l'un des premier et deuxième traitements thermiques peut être effectué à une température supérieure ou égale à 1200°C, et de préférence de l'ordre de 1300°C. Ceci permet, notamment pour une structure de silicium, d'avoir un taux de dislocation intérieur à 10⁵ dislocations/cm².

Le second traitement thermique fournit l'énergie nécessaire au système pour évoluer vers un état de plus basse énergie en éliminant la plupart des dislocations qui se trouvent dans une configuration instable. Ce phénomène est activé thermiquement, donc, plus la température est élevée, plus l'effet est important. A titre d'exemple, pour du silicium épitaxié sur du silicium, un recuit de 1320°C pendant 6 heures, après l'étape d'épitaxie, permet une diminution de la densité de dislocations d'au moins un facteur dix.

D'autres caractéristiques et avantages de l'invention ressortiront mieux de la description qui va suivre, donnée à titre illustratif et non limitatif, en référence aux figures annexées.

### Brève description des figures

- la figure 1 illustre schématiquement la structure résultant d'une implantation d'ions dans un substrat, et après un premier traitement thermique,
- la figure 2 illustre schématiquement une étape d'épitaxie d'une couche de silicium, conformément à l'invention,
- la figure 3 illustre schématiquement la structure finale obtenue après un second traitement thermique,
- la figure 4 est un graphe exprimant la densité de dislocations (en cm⁻²) de structures finales en fonction de la durée du premier traitement thermique (en heures) et pour différentes températures de premier traitement thermique,
- la figure 5 est un graphe exprimant la densité de dislocations (en cm⁻²) de structures finales en fonction de la durée du premier traitement thermique (en heures) et pour des structures ayant subi une épitaxie dans des conditions différentes,
- la figure 6 est un graphe exprimant la densité de dislocations (en cm⁻²) de structures finales en fonction de la durée du premier traitement thermique (en heures), et pour différentes températures de traitement thermique, l'épitaxie des structures ayant été conduite dans des conditions différentes de celle des structures de la figure 4,
- la figure 7 est un graphe exprimant la densité de dislocations (en cm⁻²) de structures finales en fonction de l'épaisseur de la couche d'épitaxie (en µm),
- la figure 8 est un graphe exprimant la densité de dislocations (en cm⁻²) de structures finales en fonction de la durée du premier traitement thermique (en heures), avec des substrats de qualités cristallines différentes.

### Exposé détaillé de modes de mise en oeuvre particuliers du procédé

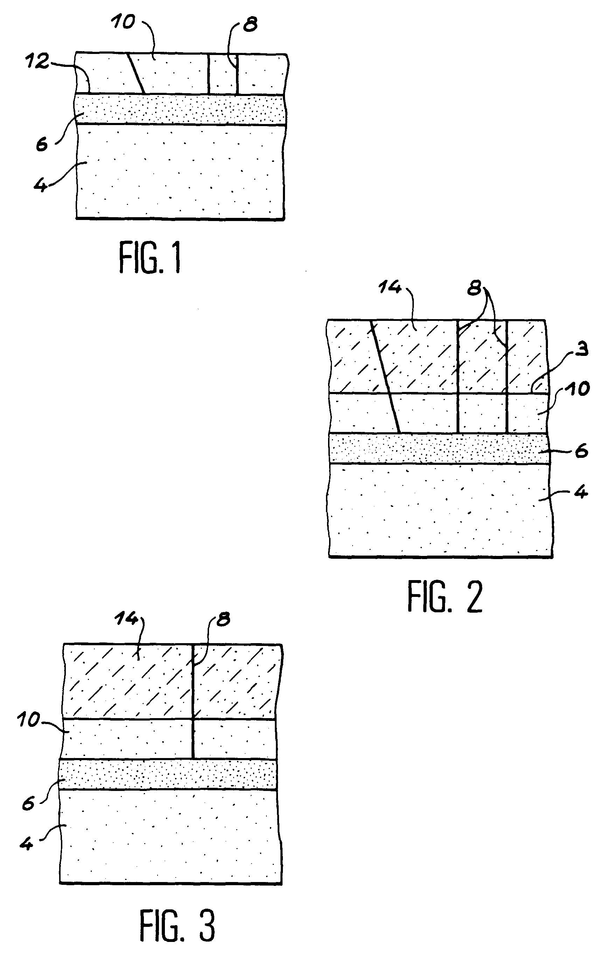

La figure 1 illustre la structure résultant après implantation et premier traitement thermique selon le procédé conforme à l'invention.

La première étape du procédé consiste à implanter des ions oxygènes O⁺ ou O₂⁺ dans un substrat 4, par exemple de silicium monocristallin, à travers une surface 3 pour former une couche d'oxyde enterrée 6.

Selon le cas, la couche peut varier d'une zone constituée de petits agrégats d'oxyde noyés dans le silicium à une zone continue. La dose d'implantation d'oxygène est de préférence supérieure à 10¹⁵cm⁻², et par exemple de l'ordre de 1,8.10¹⁸cm⁻² dans les applications courantes. L'énergie d'implantation est de l'ordre de 200 keV. Dans ces conditions, après le premier traitement thermique, on peut obtenir une couche enterrée d'une épaisseur de 400 nm.

La deuxième étape du procédé consiste en un premier traitement thermique de la structure qui comporte maintenant la couche d'oxyde enterrée 6 divisant le substrat en deux parties : un film de silicium 10 et la masse 4 du substrat.

Lors de cette deuxième étape, ou étape de prérecuit, la structure est portée à une température inférieure à la température de fusion du semi-conducteur mais suffisante pour conditionner le substrat comme par exemple 1320°C, pendant 6 heures. On peut noter à ce sujet que la température n'est pas en soi critique pour ce premier traitement thermique, elle peut varier dans une gamme allant de l'ordre de 800°C à 1405°C.

Plus les températures utilisées sont faibles, plus la durée du traitement thermique est longue.

Le même résultat peut être obtenu avec des traitements thermiques à différentes températures mais en adaptant la durée du traitement.

En fonction de la température, différents mécanismes peuvent apparaître : pour des températures de traitement thermique intermédiaires de l'ordre de 950 à 1200°C, seuls de petits précipités de silice présents après l'implantation d'oxygène sont dissous. A l'interface Si/SiO₂ référencée 12 subsistent de plus gros précipités entre lesquels sont piégées de nombreuses dislocations. Les seules dislocations débouchant à la surface sont soit celles issues des défauts de reconstruction pendant l'implantation oxygène 2, soit celles issues de la zone défectueuse proche de l'interface 12. Cette zone est suffisamment proche de la surface pour induire des dislocations traversantes après recuit. Pour des températures de traitement thermique plus élevées, supérieures à 1300°C, il n'y a plus de précipités de silice dans le film de silicium et les dislocations 8 sont toutes traversantes avec une densité allant de 10⁵ à 10⁶cm⁻² pour le procédé SIMOX standard (1,8.10¹⁸ions O⁺/cm²). Le traitement thermique à haute température fournit au système l'activation thermique qui lui permet d'évoluer vers un équilibre thermodynamique (métastable).

Comme indiqué plus haut, cette évolution s'accompagne notamment d'un relâchement de certaines contraintes, se traduisant par une redistribution des dislocations 8, voire l'apparition de nouvelles dislocations.

L'étape suivante du procédé est illustrée à la figure 2. Une couche 14 de silicium est formée par épitaxie sur la face 3 du substrat 4 dans lequel a été formée au préalable la couche d'oxyde enterrée 6.

L'épaisseur de la couche 14 est par exemple de 1µm, et en tout cas supérieure à 0,05µm pour que le procédé s'avère d'une efficacité significative. Il apparaît que les dislocations 8 débouchant sur la surface 3 se prolongent lors de l'épitaxie dans la couche 14.

Lorsque l'état de la surface 3 du substrat, à travers laquelle sont implantés les ions oxygène, est correctement maîtrisée, en particulier en ce qui concerne les problèmes de contamination, la présence ou non d'oxygène et l'orientation cristalline, le taux de dislocations est de l'ordre de 10⁵cm⁻², la principale source de défauts cristallins étant les dislocations qui croissent avec la couche d'épitaxie 14 à partir de la zone perturbée à l'interface 12 de la couche 6 d'oxyde et du film de silicium 10.

Après l'épitaxie, l'ensemble de la structure subit le second traitement thermique pour obtenir finalement le résultat de la figure 3 sur laquelle est représenté un nombre inférieur de dislocations 8. Les dislocations dont la longueur a augmenté lors de l'épitaxie et dont la configuration énergétique est devenue instable disparaissent lors de ce traitement.

Ce second traitement thermique a lieu dans une gamme de températures allant également de l'ordre de 800°C à 1400°C, les durées des traitements variant également en fonction des températures choisies. On expose par exemple la structure à une température de 1320°C pendant 6 heures environ.

Il convient à présent, pour mieux illustrer l'importance des différents paramètres cités ci-dessus d'analyser leur influence sur le nombre de dislocations dans différentes configurations expérimentales.

Comme évoqué plus haut, le couple temps-température du premier traitement thermique est d'une très grande importance.

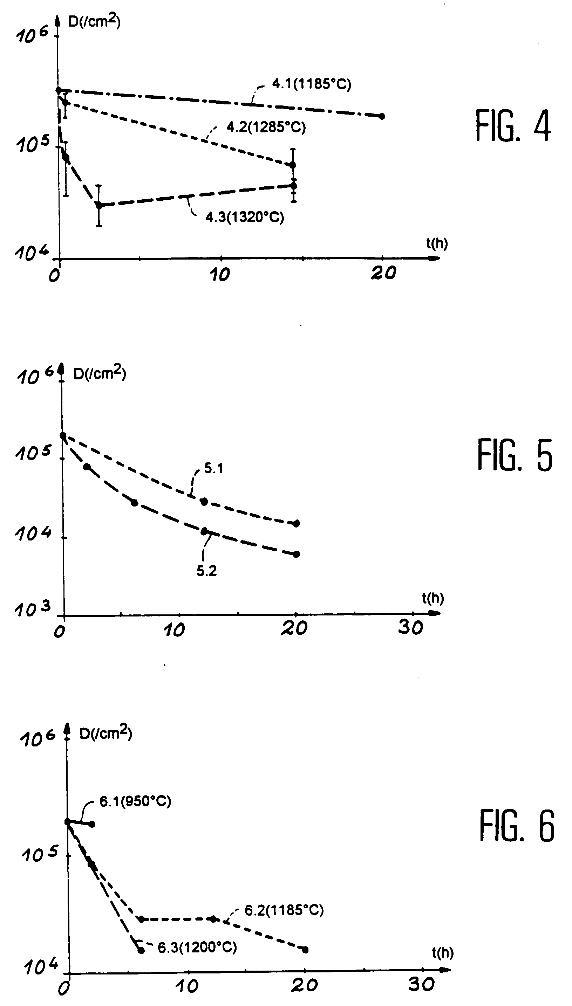

Le graphe de la figure 4 indique en fonction de la durée du premier traitement thermique en abscisse (en heures), le nombre D de dislocations par cm² présentes dans la structure finale en ordonnée et ce pour des températures de premier traitement thermique respectivement égales à 1185°C (4.1), 1285°C (4.2) et 1320°C (4.3). Ces mesures ont été effectuées sur un échantillon dont la couche 14 d'une épaisseur de 1 µm, a été formée dans un bâti de type Barrel, à une pression de l'ordre de 1,2.10³Pa (90 torrs), et qui a subi un deuxième traitement thermique de 6 heures à 1320°C. Il apparaît qu'à la fois la durée et la température du premier traitement thermique influent sur la diminution du nombre final de dislocations.

Un résultat particulièrement probant est obtenu avec un premier traitement thermique effectué à 1320°C pendant 6 heures qui permet d'obtenir une structure finale avec une densité de dislocations diminuée environ d'un facteur 10.

Il apparaît par ailleurs que pour une température du premier traitement thermique de 1185°C la diminution du nombre de dislocations n'est que très faible. Comme cela apparaît dans la suite, ce résultat tient en grande partie aux conditions d'épitaxie (équipement, procédé).

C'est notamment ce que montre la figure 5 qui indique en fonction de la durée du premier traitement thermique en abscisse, la densité D de dislocations dans la structure finale après le second traitement thermique, en ordonnée.

Dans les essais de la figure 5, le premier traitement thermique a été effectué à une température de 1185°C, le second traitement thermique à 1320°C pendant 6 heures et la couche d'épitaxie présente une épaisseur de 1µm.

Les courbes 5.1 et 5.2 représentent des résultats obtenus avec des structures où la couche d'épitaxie a été réalisée respectivement dans un bâti de type Barrel fonctionnant à basse pression et dans un bâti de type "monoplaquette" à pression atmosphérique.

Il apparaît que quel que soit le mode de mise en oeuvre de l'épitaxie le procédé s'avère fonctionnel. Cependant, le budget thermique, c'est à dire le couple température durée, du premier traitement thermique, nécessaire pour obtenir finalement une réduction efficace du nombre de dislocations, peut varier en fonction des conditions de l'épitaxie.

Alors qu'à la figure 4, la diminution des dislocations était faible pour un traitement à 1185°C, elle est supérieure d'un facteur 10 dans le cas des courbes 5.1 et 5.2 de la figure 5, pour une durée de premier traitement équivalente (20 heures). Ces différences de résultats sont dues en particulier à des conditions d'épitaxie différentes (natures de gaz, "prebake", montée en température,...)

En effet, il faut noter à ce sujet que le procédé d'épitaxie peut comporter lui-même un traitement thermique ("prebake") de préparation de la surface, qui peut influencer ou modifier le premier traitement thermique de l'invention.

Bien que la température du premier traitement thermique ne soit pas à elle seule un facteur déterminant pour l'efficacité du procédé, à condition qu'elle soit suffisante pour le conditionnement du substrat conformément à l'invention, il apparaît néanmoins à la figure 6 que l'efficacité du procédé augmente avec la température du premier traitement thermique. La figure 6 exprime en ordonnée la densité finale D de dislocations (/cm²) de structures qui ont subi respectivement un premier traitement à une température de 950°C, courbe 6.1, 1185°C, courbe 6.2 et 1200°C, courbe 6.3.

La durée du premier traitement thermique est reportée en abscisse et exprimée en heures. L'étape d'épitaxie a été réalisée dans un bâti de type "monoplaquette" à pression atmosphérique, avec une épaisseur de couche épitaxiée de 1µm d'épaisseur; la durée du second traitement thermique est maintenue à 6 heures avec une température toujours de 1320°C. On remarque que dans ces conditions un premier traitement thermique de 950°C pendant 2 heures est insuffisant pour observer une diminution sensible de dislocations dans la structure finale.

Pour des traitement à 1185°C et 1200°C par contre, la diminution des dislocations devient rapidement appréciable.

On peut noter également en comparant la figure 6 et les figures 4 et 5 que pour un premier traitement de 1185°C (4.1, 5.2 et 6.2) des résultats très différents sont observés. Ceci est dû notamment au fait que l'épitaxie a été conduite dans des conditions différentes pour les essais correspondant à ces deux figures.

Un exemple de mise en oeuvre du procédé avec une structure de silicium et dans lequel le premier et de deuxième traitements thermiques sont effectués à 1300°C, permet de mieux comprendre, et de proposer une explication de l'influence de la température sur le mécanisme d'élimination des dislocations. Dans cet exemple, après une implantation d'oxygène et un premier traitement thermique à 1300°C, les dislocations présentes dans le film supérieur de silicium sont toutes traversantes et leurs extrémités se trouvent à la surface et à l'interface Si-SiO₂.

L'étude de ces dislocations par révélation chimique indique que les dislocations sont par paires. Ces paires sont orientées suivant des directions préférentielles bien précises. Cette configuration est stable car un deuxième traitement thermique ne modifie pas la configuration des dislocations. Il existe donc des forces d'interaction entre deux dislocations formant une paire.

Après épitaxie, les dislocations sont toujours par paires et leur densité est toujours la même. Cependant, les paires n'ont plus d'orientation préférentielle. L'épitaxie a donc modifié la configuration des dislocations et a permis une diminution significative des forces d'interaction entre les dislocations formant une paire. Les dislocations sont alors dans une configuration instable. Il suffit alors d'effectuer le deuxième traitement thermique pour donner de l'énergie au système et le faire évoluer vers un état de plus faible énergie. Au cours de ce deuxième traitement thermique, les dislocations peuvent migrer et certaines dislocations peuvent se recombiner. On observe alors une diminution du taux de dislocations.

Au cours de ce procédé, on assiste à une élimination de dislocations par recombinaison. Pour cela, il est nécessaire que ces dislocations puissent migrer, c'est-à-dire qu'elles ne soient pas piégées sur un défaut comme par exemple un précipité d'oxyde dans le film supérieur de silicium. Ceci montre l'importance d'effectuer au cours du procédé au moins un des deux traitements thermiques à une température suffisante pour que tous les précipités d'oxyde (SiO₂) soient dissous.

Un autre paramètre pouvant influencer le résultat de procédé est l'épaisseur de la couche d'épitaxie.

Comme indiqué dans ce qui précède l'épitaxie a comme but d'augmenter la longueur des dislocations afin de les placer dans une configuration énergétique instable.

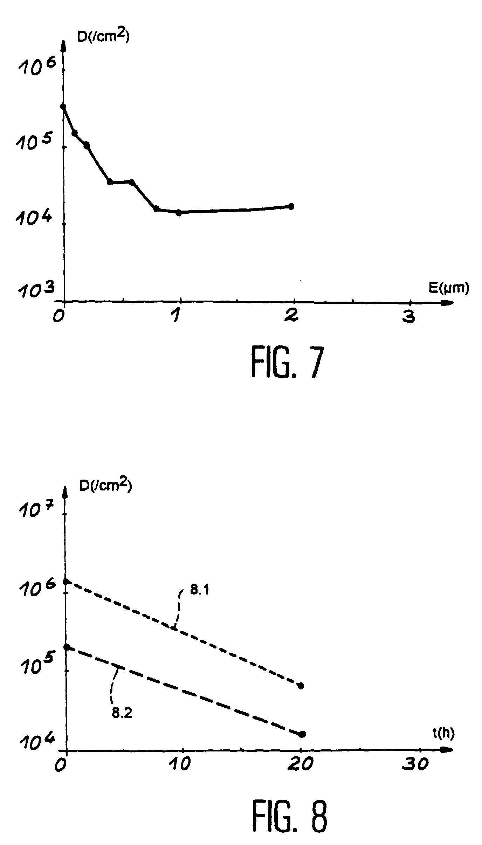

Pour évaluer l'influence de l'épaisseur de la couche d'épitaxie, des essais ont été effectués toujours dans un bâti de type "monoplaquette", à pression atmosphérique avec un premier traitement thermique à 1185°C pendant 20 heures, et un second traitement thermique à 1320°C pendant 6 heures ; la figure 7 indique en ordonnée la densité D de dislocations (/cm²) pour différentes structures avec différentes épaisseurs de couche d'épitaxie (reportées en abscisse en µm).

Les mesures montrent que même si le procédé donne des résultats pour des couche d'épitaxie de relativement faible épaisseur, une diminution significative de la densité de dislocations est atteinte avec des structures où l'épaisseur de cette couche est de l'ordre du micromètre ou supérieure à 1 µm.

La figure 8, permet de mettre en évidence l'influence de la qualité du matériau de départ, c'est-à-dire le substrat mis en oeuvre. Elle indique en fonction de la durée de premier traitement thermique (exprimée en heures) la densité D de dislocations (/cm²) finale, c'est-à-dire après le deuxième traitement thermique et ce pour un échantillon (courbe 8.1) dont la densité de dislocations initiale, c'est-à-dire avant ce deuxième traitement thermique est de l'ordre de 10⁶cm⁻², et un échantillon (courbe 8.2) dont la densité de dislocations initiale est de l'ordre de 10⁵cm⁻². Le second traitement thermique a été effectué à 1320°C pendant 6 heures et l'épitaxie, d'une épaisseur de 1µm, a été effectuée dans un bâti de type monoplaquette à pression atmosphérique. Il apparaît que dans chacun des cas avec un premier traitement thermique à 1185°C pendant 20 heures, la densité des dislocations a diminué au moins d'un facteur 10.

Finalement, grâce au procédé de l'invention, il est possible de réaliser des structures SOI de grande qualité cristalline. Le choix de certains paramètres, notamment de température, permet en outre d'optimiser le procédé pour différents types d'installations de fabrication de ces structures, ce qui permet sa mise en oeuvre facile et économique dans de nombreuses applications.

Les documents, qui sont mentionnés dans la présente description, dont les suivants :

### DOCUMENT (1) :

Defect Phenomena in SIMOX Through Epitaxy, H. Min Liaw, M. Tomozane, and P. Fejes, Proc. of the 1990 Electrochem. Soc. Spring Meeting, Montreal, Quebec, Canada, May 8-11, p. 129.

### DOCUMENT (2) :

A Mogro-Campero, N. Lewis and S.A. Al-Marayati Mat. Res. Soc. Symp. Proc., vol. 107, 1988, p.123 ssq.

### DOCUMENT (3) :

Silicon Epitaxial Growth on Silicon on insulator structures by rapid thermal processing chemical vapor deposition, T.Y. Hsieh, Kith Jung and D.L. Kwong, Appl. Phys. Lett. 57(23), 3 December 1990.

### DOCUMENT (4) :

Demande de brevet français FR-2 616 590

## Revendications

1. Procédé de réalisation d'une structure épitaxiée à faible taux de dislocations, cette structure comprenant une couche d'oxyde (6) dans un substrat (4) en un matériau semi-conducteur, ce procédé comportant successivement :
- au moins une implantation d'ions oxygène (2) dans le substrat (4), à travers une surface(3) de ce dernier, pour former une couche enterrée d'oxyde (6),
- au moins un premier traitement thermique de conditionnement du substrat à une température inférieure à la température de fusion du matériau semi-conducteur,
- une épitaxie d'une couche (14) d'un matériau semi-conducteur sur la surface du substrat,
- un second traitement thermique à une température inférieure à la température de fusion du matériau semi-conducteur du substrat et à celle du matériau de la couche épitaxiée pour éliminer des dislocations (8) de la structure se trouvant dans une configuration énergétique instable,
et dans lequel le premier traitement thermique est effectué à une température choisie dans une gamme de température de 800°C à 1405°C et le deuxième traitement thermique est effectué à une température supérieure ou égale à 1200°C, pour dissoudre sensiblement tous les précipités d'oxyde formés au cours de l'implantation et pour libérer les dislocations qui se recombinent alors au cours du deuxième traitement thermique.

2. Procédé selon la revendication 1, caractérisé en ce que le matériau semi-conducteur est du silicium.

3. Procédé selon la revendication 1, dans lequel le deuxième traitement thermique est effectué à une température de l'ordre de 1300°C.

4. Procédé selon la revendication 1, caractérisé en ce que la couche d'épitaxie de matériau semi-conducteur a une épaisseur supérieure ou égale à 0,05 µm.

## Claims

1. Process for producing an epitaxied structure with a low dislocation density, said structure comprising an oxide layer (6) in a semiconductor material substrate (4), the process successively involving:
- at least one implantation of oxygen ions (2) in the substrate (4) through a surface (3) of the latter in order to form a buried oxide layer,
- at least one first conditioning heat treatment of the substrate at a temperature below the melting point of the semiconductor material,
- an epitaxy of a semiconductor material layer (14) on the substrate surface and
- a second heat treatment at a temperature lower than the melting point of the semiconductor material of the substrate and that of the material of the epitaxied layer in order to eliminate most of the dislocations of the structure in an unstable energy configuration,
and wherein the first heat treatment is performed at a temperature chosen in a temperature range of 800 to 1405°C and the second heat treatment is carried out at a temperature higher than or equal to 1200°C, in order to dissolve substantially all the oxide precipitates formed during implantation and free the dislocations which then recombine during the second heat treatment.

2. Process according to claim 1, characterized in that the semiconductor material is silicon.

3. Process according to claim 1, wherein the second heat treatment takes place at a temperature of approximately 1300°C.

4. Process according to claim 1, characterized in that the epitaxy layer of semiconductor material has a thickness equal to or greater than 0.05 µm.

## Patentansprüche

1. Verfahren zur Herstellung einer Struktur mittels Epitaxie mit niedrigen Konzentrationsdefekten, wobei diese Struktur in einem Substrat (4) eine Oxidschicht (6) aus einem Halbleitermaterial enthält und dieses Verfahren folgende Schritte umfasst::
- wenigstens eine Sauerstoffionenimplantation (2) in dem Substrat (4), durch eine Oberfläche (3) dieses letzteren hindurch, um eine begrabene Oxidschicht (6) zu bilden,
- wenigstens eine erste thermische Konditionierungsbehandlung des Substrats mit einer Temperatur, die niedriger ist als die Schmelztemperatur des Halbleitermaterials,
- eine Epitaxie einer Schicht (14) aus einem Halbleitermaterial auf der Oberfläche des Substrats,
- eine zweite thermische Behandlung bei einer niedrigeren Temperatur als der Schmelztemperatur des Halbleitermaterials des Substrats und der des Materials der Epitaxie-Schicht, um Konzentrationsdefekte (8) der Struktur zu eliminieren, die sich in einer instabilen energetischen Konfiguration befindet,
wobei die erste thermische Behandlung bei einer Temperatur durchgeführt wird, die in einem Temperaturbereich von 800°C bis 1450°C gewählt wird, und die zweite thermische Behandlung bei einer Temperatur erfolgt, die höher als oder gleich 1200°C ist, um im wesentlichen alle Oxidniederschläge aufzulösen, die sich im Laufe der Implantation bilden, und um die Konzentrationsdefekte freizumachen, die sich dann im Laufe der zweiten thermischen Behandlung rekombinieren.

2. Verfahren nach Anspruch 1, dadurch gekennzeichnet, dass das Halbleitermaterial Silizium ist.

3. Verfahren nach Anspruch 1, bei dem die zweite thermische Behandlung bei einer Temperatur in der Größenordnung von 1300°C erfolgt.

4. Verfahren nach Anspruch 1, dadurch gekennzeichnet, dass die Epitaxie-Schicht aus Halbleitermaterial eine Dicke größer als oder gleich 0,05 µm hat.
